# FASCICULE DE BREVET EUROPEEN

(11) **EP 0 887 854 B1**
(45) Date de publication et mention de la délivrance du brevet: **22.11.2006**
(21) Numéro de dépôt: 98401539.6
(22) Date de dépôt: 23.06.1998
(51) Int. Cl.: H01L 21/74, H01L 21/04, H01L 23/48, H01L 21/768

(54) **Structure à composant microélectronique en matériau semi-conducteur difficile à graver et à trous métallisés**
Mikroelektronische Struktur von einem schwierig zu ätzenden Material und metallisierte Löcher
Microelectronic structure of a semiconductor material that is difficult to etch and metallized holes

(30) Priorité: 25.06.1997 FR 9707922
(43) Date de publication de la demande: 30.12.1998
(73) Titulaire: COMMISSARIAT A L'ENERGIE ATOMIQUE, 75015 Paris (FR)
(72) Inventeur: Billon, Thierry, Lotissement "Les Parcs de, 38500 Coublevie (FR)
(74) Mandataire: Poulin, Gérard

(56) Documents cités:
- EP-A- 0 317 445
- US-A- 5 343 071
- US-A- 5 436 174
- US-A- 5 574 295
- CIOCCIO DI L ET AL: "SILICON CARBIDE ON INSULATOR FORMATION USING THE SMART CUT PROCESS" ELECTRONICS LETTERS, vol. 32, no. 12, 6 juin 1996, page 1144/1145 XP000620727
- LINDER S ET AL: "FABRICATION TECHNOLOGY FOR WAFER THROUGH-HOLE INTERCONNECTIONS AND THREE-DIMENSIONAL STACKS OF CHIPS AND WAFERS" PROCEEDING OF THE WORKSHOP ON MICRO ELECTRO MECHANICAL SYSTEMS (MEM, OISO, JAN. 25 - 28, 1994, no. WORKSHOP 7, 25 janvier 1994, pages 349-354, XP000528439 INSTITUTE OF ELECTRICAL AND ELECTRONICS ENGINEERS
- PATENT ABSTRACTS OF JAPAN vol. 017, no. 110 (E-1329), 8 mars 1993 & JP 04 293234 A (SHIMADZU CORP), 16 octobre 1992

## Description

### Domaine technique

La présente invention concerne une structure à composant microélectronique en matériau semi-conducteur difficile à graver et à trous métallisés.

Elle concerne plus précisément le domaine de la réalisation de circuits intégrés sur des matériaux semi-conducteurs à grande bande interdite tels que le carbure de silicium et le nitrure de gallium. Il s'agit principalement de structures ou dispositifs électroniques nécessitant le report d'électrodes métalliques en face arrière des composants. D'une manière plus particulière, il s'agit de créer des trous métallisés à travers une couche active de composants semi-conducteurs.

Le carbure de silicium et le nitrure de gallium sont des matériaux semi-conducteurs à grande bande interdite et qui possèdent des propriétés physiques et électriques qui les prédisposent pour :
- les applications d'électronique hyperfréquence de puissance,
- les applications d'électronique fonctionnant à hautes températures,
- les applications d'optronique travaillant en émission ou en détection dans le domaine de l'ultraviolet.

L'élaboration de ces matériaux est actuellement dans une phase de développement. Dans le cas du carbure de silicium, on constate actuellement une grande différence au niveau de la qualité cristalline entre des films minces épitaxiés sur le même semi-conducteur (homo-structure) et des films minces réalisés sur un autre matériau (hétéro-structure). Les films minces obtenus selon le deuxième procédé sont généralement polycristallins ou monocristallins granulaires ou encore comportent de nombreux défauts et dislocations. Ceci a pour conséquence directe une dégradation significative générale des caractéristiques électriques des composants électroniques réalisés sur cette structure. De plus, les arrangements cristallographiques de ce semi-conducteur sont tels qu'ils limitent la possibilité de contrôle d'obtention d'un polytype cristallin plutôt qu'un autre. A titre d'exemple, le polytype de variété cubique appelé 3C-SiC ou βSiC est le seul polytype cristallin réalisable sur silicium (système cubique). Or, de par ses propriétés électriques, ce polytype n'est pas le meilleur candidat pour la majorité des dispositifs électroniques, les polytypes de la famille α-SiC de variété hexagonale appelés 4H et 6H-SiC étant les plus performants dans ce cas. Ceux-ci sont actuellement élaborés sur substrats massifs de même nature et ne peuvent pas être épitaxiés sur silicium. Ce procédé d'élaboration ne permet pas la réalisation de structures où un film mince de carbure de silicium, d'une très bonne qualité cristalline, est disposé sur d'autres matériaux isolants et/ou semi-conducteurs tels que l'oxyde de silicium et le silicium, respectivement. La réalisation d'isolant enterré dans une homo-structure est possible par des procédés d'implantation ionique mais cette méthode conduit généralement à l'obtention de films comportant un taux élevé de défauts néfastes à la réalisation de composants semi-conducteurs.

Seul les procédés actuels de transfert de films minces par collage permettent la réalisation de structures comportant un film mince utilisable pour le développement de composants semi-conducteurs de pointe. Ce procédé de collage peut être associé, soit à une pré-implantation d'espèces générant une zone de fracture, soit à un procédé d'élimination par gravure, rodage ou polissage, conduisant à isoler un film mince.

Le carbure de silicium est un matériau qui est très stable physiquement et chimiquement dans la gamme de température de 0 à 1000°C. La dureté et la densité de ce matériau sont telles que la gravure de ce matériau est très difficile. La gravure par voie humide s'effectue dans des bains de sels fondus pour des températures supérieures à 500°C.

Les procédés de gravure par voie sèche du carbure de silicium nécessitent de nombreuses études tant au niveau du masque que des conditions propres à la gravure. De façon générale, les équipements de gravure du type RIE (Reactive Ion Etching) permettent d'atteindre des vitesses de gravure inférieures à 0,2 µm/min. Les systèmes mettant en oeuvre de fortes densités de flux (plasma assistée par source micro-onde) sont les seuls actuellement à donner des vitesses supérieures à celles précédentes. Les différents types de masques étudiés sont du type organique ou minéral. A l'inverse des masques de type organique (résines photosensibles) qui autorisent des profondeurs de zones gravées très faibles (inférieures à 0,5 µm), les masques de type minéral (nickel-aluminium) engendrent des sélectivités de gravure très élevées. Ces sélectivités permettent d'atteindre des profondeurs gravées de l'ordre de quelques micromètres, performances obtenues conjointement à l'obtention de vitesse de gravure "raisonnables". Les meilleurs résultats de gravure par voie sèche sont actuellement des vitesses de l'ordre de 0,3 µm/min, les profondeurs de zones gravées étant de l'ordre de quelques micromètres. Ces résultats sont présentés dans les articles suivants :
- J.B. Casady et al. "Reactive Ion Etching of 6H-SiC using NF₃", International Conference on Silicon Carbide and Related Materials 1995, (Kyoto, Japon), Inst. Phys. Conf. Ser. N° 142, Chapter 3 ;
- F. Lanois et al. "Angle Etch Control for Silicon Power Devices" Applied Physics Letters, Vol. 69, 8 juillet 1996).

L'épaisseur des substrats SiC actuels étant comprise entre 200 à 400 µm, les temps de gravure pour créer des trous traversants ne sont pas envisageables sur un substrat massif en carbure de silicium (homo-structure).

L'élaboration de nitrure de gallium, actuellement uniquement sous forme de films minces, s'effectue dans certains cas à partir de substrat en carbure de silicium. Le problème est alors identique pour des composants réalisés sur un film mince en nitrure de gallium.

Parmi les applications envisagées pour ces circuits élaborés sur du carbure de silicium ou du nitrure de gallium, on peut citer l'hyperfréquence de puissance et les matrices et réseaux de composants.

Pour le premier type d'application, les composants fonctionneront à hautes fréquences (environ 1 GHz et au-delà) et traiteront de fortes puissances. Ces composants, habituellement réalisés en silicium et/ou en arséniure de gallium, sont alors du type "transistor à effet de champ". De telles applications sont en cours de développement sur du carbure de silicium ou du nitrure de gallium. Les séquences qui permettent la réalisation de tels composants sont très proches de celles couramment développées sur silicium ou arséniure de gallium.

Les systèmes de puissance fonctionnant à hautes fréquences imposent la conception de transistors ayant des caractéristiques dimensionnelles très poussées. On note ainsi de très faibles longueurs de grille, inférieures au µm ainsi que de grandes largeurs de grille, de l'ordre du millimètre. Tous ces dispositifs doivent être assemblés sur un support isolant à semi-isolant afin de s'approcher au mieux des performances maximales accessibles : hautes fréquences (f_{T}, fₘₐₓ), rendements de puissance ajoutée élevés.

Ces transistors sont alors conçus par de nombreux doigts de grille, structures nécessitant l'interdigitation des métallisations de drains et de sources. Une même étape de métallisation pour les contacts de grilles et de drains forme deux bus respectifs qui, de par leur imbrication, exclut toute prise de contact sur les zones de sources situées au centre. Les sources doivent impérativement être reliées entre elles.

Les technologies actuelles mettent en oeuvre des méthodes dites de ponts à air, les métallisations étant reliées entre elles par la face avant. Ces méthodes nécessitent alors une minimisation importante de tous les éléments parasites (capacités et inductances) que peuvent créer ces structures. Au-delà de certaines valeurs critiques, les performances électriques générales des transistors sont alors limitées par ces éléments. Une seconde technique consiste donc à créer des trous métallisés à travers toute l'épaisseur de matériau semi-conducteur.

On réalise alors l'interconnexion de toutes les électrodes de sources communes par ces trous métallisés et des lignes ou des plans de métallisation situés en face arrière du composant. Le composant à réaliser devra donc disposer de contacts grille et drain en face avant et de contacts source en face arrière, la majorité de l'épaisseur du substrat étant de type isolant, semi-isolant ou fortement résistif. De telles connexions verticales permettent de plus une meilleure dissipation thermique du composant.

Actuellement on connaît la réalisation de composants hyperfréquences ou optroniques en carbure de silicium ou en nitrure de gallium. A titre d'exemple, on peut se reporter à l'article "4H-SiC MESFET'S with 42 GHz fₘₐₓ" par S. Sriram et al, paru dans IEEE Electron Device Lett., vol. 17, no. 7, pp. 369-371, juillet 1996.

Les limitations des performances électriques des transistors actuellement réalisés se résument essentiellement en l'absence de substrat de type semi-isolant à isolant (fortes résistivités supérieures à quelques 10⁵ Ω.cm à température ambiante) ainsi que l'absence de technologies optimisées. Les seuls dispositifs démonstrateurs actuels du carbure de silicium utilisent en effet des technologies avec métallisation par pont à air. Ces réalisations sont néanmoins très récentes. Si l'on regroupe l'ensemble des publications actuelles sur le sujet, on peut relever en priorité l'absolue nécessité de réaliser ces dispositifs sur un support hautement résistif à isolant. La seconde nécessité sera la possibilité de créer sur ces composants une ou plusieurs connexions verticales à travers la structure : connexions permettant la création de chemins propres à la conduction électrique et la dissipation thermique. Ce dernier point sera en effet très critique sur une structure isolante ou ayant des coefficients de conductivité thermique peu élevés. Une structure intéressante devra à ce niveau être optimisée tant au niveau de l'isolant enterré (minimisation de la résistance thermique d'une telle couche par limitation de l'épaisseur de cette couche ; optimisation de l'épaisseur et de la constante diélectrique de cette couche pour minimiser les couplages hyperfréquences parasites, optimisation liée à la contrainte précédente) que de la constitution du substrat support (minimisation de la résistance thermique d'une telle couche par limitation de l'épaisseur de cette couche ; optimisation de l'épaisseur, de la résistivité voire du caractère isolant et de la constante diélectrique de cette couche pour minimiser les couplages hyperfréquences parasites, optimisation liée à la contrainte précédente).

Pour le second type d'application, les composants réalisés sur le carbure de silicium ou nitrure de gallium peuvent être arrangés librement sous formes de lignes et/ou de matrices. Il peut s'agir de transistors définis comme précédemment, de diodes, de capteurs, d'éléments passifs, de photo-composants mais aussi d'ensembles complexes combinant ces éléments entre eux.

Chaque élément de base dispose par conséquent de lignes de métallisations qui lui sont propres mais aussi d'un ensemble de points de contacts en vue d'être adressable individuellement (pour un adressage matriciel type ligne/colonne par exemple). L'arrangement des éléments entre eux requiert une densité d'intégration élevée, ce qui exclut toute possibilité de disposer la connectique d'adressage en face avant du composant final.

Des démonstrations de composants unitaires ont été effectuées pour un large domaine d'applications. Cependant, il n'existe pas actuellement de démonstrateurs significatifs à forte densité d'intégration mettant en oeuvre un assemblage en ligne ou matrice de composants unitaires. L'absence de techniques avec trous métallisés est l'une des raisons majeures au manque de développement des circuits précédents. Le principal obstacle à l'existence de tels procédés de réalisation est le même que dans le premier cas : la gravure totale dans toute l'épaisseur d'un substrat massif en carbure de silicium est totalement irréalisable actuellement.

Le document « Silicon carbide on insulator formation using the Smart Cut process » de L. Di Cioccio et al., Electronics Letters, vol. 32, n°12, pages 1144 et 1145, 6 juin 1996, divulgue la réalisation d'une structure comprenant une couche mince de carbure de silicum reportée sur une face oxydée d'un substrat de silicium. La couche mince de carbure de silicium est délimitée par implantation ionique dans un substrat du même matériau. La réalisation d'un composant microélectronique dans la couche mince est indiquée.

### Exposé de l'invention

La présente invention autorise la création de trous métallisés à travers une couche semiconductrice en carbure de silicium ou en nitrure de gallium en conférant à cette dernière une épaisseur restreinte (d'environ quelques µm) et en prévoyant qu'elle repose sur un ensemble porteur adapté à l'application visée. Les techniques de gravure actuellement développées sont alors tout à fait applicables à une telle épaisseur. L'ouverture totale du trou métallisé s'effectue ensuite par la gravure du substrat porteur.

L'invention a donc pour objet un procédé de réalisation d'une structure comportant un composant microélectronique réalisé dans un matériau semi-conducteur difficile à graver, comprenant la solidarisation d'un film mince dudit matériau semi-conducteur difficile à graver sur la face avant d'un premier substrat en matériau facile à graver et servant de support, cette solidarisation fournissant ladite structure, le composant microélectronique étant réalisé dans le film mince, un trou traversant étant gravé dans la structure et métallisé de façon à relier électriquement une électrode formée sur la face arrière du premier substrat à une électrode du composant microélectronique.

Ce procédé peut comporter les étapes suivantes :
- préparation du premier substrat pour lui conférer une face avant et une face arrière appropriées aux étapes suivantes,
- préparation d'un deuxième substrat comportant ledit matériau semi-conducteur difficile à graver pour lui conférer une face avant appropriée aux étapes suivantes,
- mise en contact intime du premier et du deuxième substrat par solidarisation de leurs faces avant,
- élimination d'une partie du deuxième substrat de façon à ne laisser subsister, sur la face avant du premier substrat, qu'un film mince constitué dudit matériau semi-conducteur difficile à graver,
- réalisation du composant microélectronique sur le film mince, avec ses électrodes,
- réalisation d'une électrode sur la face arrière du premier substrat,
- réalisation d'un trou traversant dans la structure, entre la face arrière du premier substrat et la face libre du film mince,
- métallisation du trou traversant et mise en contact électrique du trou traversant métallisé d'une part avec une électrode du composant microélectronique, d'autre part avec électrode située sur la face arrière du premier substrat.

Selon une première variante de réalisation, il peut être prévu, lors de l'étape de préparation du deuxième substrat, une implantation ionique de ce deuxième substrat au travers de sa face avant afin de délimiter ledit film mince grâce à la formation d'une couche de microcavités dans le deuxième substrat, l'implantation ionique étant menée avec une dose suffisante pour permettre la création d'une ligne de fracture le long de la couche de microcavités lors d'un traitement thermique de la couche de microcavités réalisé au cours de l'étape consistant à éliminer une partie du deuxième substrat.

Selon une seconde variante de réalisation, l'élimination de ladite partie du deuxième substrat peut se faire par usinage mécanique.

Le matériau facile à graver peut être du silicium, du quartz, de l'alumine, du saphir ou de l'arséniure de gallium.

Dans le cas d'un support en matériau semi-conducteur, il peut être intéressant (pour des applications hyperfréquences) de lui fournir une couche isolante, en raison de sa faible permittivité électrique, de façon à éviter les couplages électromagnétiques. Cette couche isolante peut être prise dans la famille des oxydes et des nitrures de silicium ou d'aluminium, par exemple : SiO₂, AlN, Al₂O₃ ou Si₃N₄.

Le film mince peut être constitué par une couche de carbure de silicium ou de nitrure de gallium d'environ 1 µm d'épaisseur. Il peut être constitué d'un empilement de couches de carbure de silicium et/ou de nitrure de gallium de conductivités électriques différentes (dues à des dopages différents ou à des dopages de type différent).

L'invention a aussi pour objet une structure comportant un composant microélectronique réalisé dans un matériau semi-conducteur difficile à graver, la structure comprenant un film mince dudit matériau difficile à graver et dans lequel est réalisé le composant microélectronique, le film mince étant solidaire de la face avant d'un premier substrat en matériau facile à graver et dont la face arrière du premier substrat supporte une électrode, un trou traversant métallisé reliant électriquement l'électrode arrière du premier substrat à une électrode du composant microélectronique.

### Brève description des figures

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1J illustrent une première variante du procédé de réalisation d'une structure comportant un composant microélectronique selon la présente invention,
- les figures 2A à 2C illustrent une deuxième variante du procédé de réalisation d'une structure comportant un composant microélectronique selon la présente invention.

### Description détaillée de modes de réalisation de l'invention

L'invention peut être divisée en six phases, chacune ayant requis des connaissances et recherches dans des domaines aussi variés que la chimie, la résistance des matériaux et la physique des semi-conducteurs.

La première phase de l'invention consiste à préparer séparément deux substrats. Les deux substrats peuvent être soit de type semi-conducteur ou isolant. Il s'agit ainsi principalement de matériaux tels que Si, AsGa, SiO₂, AlN, Al₂O₃, de silicates ou de composites (couches superposées) incluant ces mêmes matériaux. Les deux substrats peuvent avoir chacun un diamètre différent. Le carbure de silicium et le nitrure de gallium monocristallins n'étant disponibles que pour des diamètres de plaque proches de 50 mm alors que le silicium de diamètre 300 mm est en passe de devenir le standard mondial.

De façon plus précise, le second substrat comporte un film mince en carbure de silicium ou en nitrure de gallium à la surface de l'une de ses deux faces. Ce film mince peut lui-même être constitué de couches de dopages et de type de conductivité différents.

La seconde phase consiste à reporter une portion ou la totalité de ce film mince sur une face du premier substrat. Ce report est effectué par collage atomique de chaque substrat, technique nécessitant une maîtrise parfaite des chimies de surface et technique adaptée à chaque type de collage spécifique. Le film mince peut être séparé de son substrat d'origine selon deux méthodes. Dans un premier cas, un nombre déterminé d'atomes a été implanté au préalable à une certaine profondeur afin de créer une zone de fracture. Dans un second cas, on amincit le deuxième substrat avec des outils mécaniques (gravure, rodage, polissage). Ces deux méthodes requièrent dans chaque cas un contrôle précis de l'épaisseur de film mince à séparer. Les énergies de liaison des matériaux à traiter ont alors une influence directe sur le procédé à développer. Le film mince étant reporté à la surface du premier substrat, on obtient une structure sur laquelle sera réalisé le composant microélectronique.

La troisième phase consiste en la réalisation d'un ou de plusieurs composants semi-conducteurs actifs et passifs intégrés. Il peut s'agir de transistors, de diodes, de capteurs, d'éléments passifs, de photo-composants mais aussi d'ensembles plus complexes combinant ces éléments entre eux. La préparation de la structure est à ce niveau d'une extrême importance puisque le film mince ne doit pas être séparé ou dégradé par toutes les séquences techniques que requiert la réalisation des composants intégrés. De nombreuses études sont nécessaires pour maîtriser les bilans thermiques que devra subir le substrat avec transfert. Les dernières séquences techniques nécessaires à la réalisation de ces composants intégrés sont les métallisations sur la face avant les métallisations en face arrière.

La quatrième phase consiste alors à graver sélectivement chaque couche de la structure précédente dans les zones où l'on désire effectuer une connexion métallique verticale. Ces ouvertures ont une taille approximative de l'ordre de quelques micromètres. Les couches de faibles épaisseurs sont gravées par les méthodes décrites plus haut (gravures par voie sèche avec masques polymère ou minéral). La gravure du film mince en carbure de silicium ou nitrure de gallium ne porte alors que sur une très faible épaisseur de matériau. A titre d'exemple, on peut utiliser un procédé de gravure sèche du carbure de silicium avec une chimie réactive du type SF₆/Ar dans un équipement de type DECR (Distributed Electron Cyclotron Resonance). Les vitesses de gravure sont alors d'environ 0,2 µm/min, les rugosités et surfaces de la zone gravée n'étant pas dégradées par ce procédé. Le trou traversant la structure ne doit pas modifier de façon significative les dimensions fixées à l'origine, le paramètre critique étant de ne pas laisser une cavité non traversante. Ces techniques sont très récentes et peuvent mettre en oeuvre des procédés de photo-lithographie double face.

La cinquième phase consiste à créer une couche électriquement isolante sur les flancs des trous gravés. Cette étape peut alors être une combinaison d'oxydation thermique et de dépôts de matériau(x) isolant(s). Il est important d'assurer une parfaite homogénéité de dépôt sur toute l'épaisseur du trou.

La sixième et dernière phase consiste en la métallisation du trou gravé et des pistes en faces avant et arrière de la structure. Cette étape fait appel à des procédés de métallisation tels que les dépôts par pulvérisation, dépôts en phase vapeur (CVD) et dépôts électrolytiques. Il faut assurer une parfaite homogénéité de dépôt sur toute l'épaisseur du trou lors des métallisations successives. Cette homogénéité est nécessaire pour boucher totalement le trou sans laisser de cavité(s). Ces dernières étapes de métallisation permettent enfin de créer les connexions entre chaque élément équipotentiel.

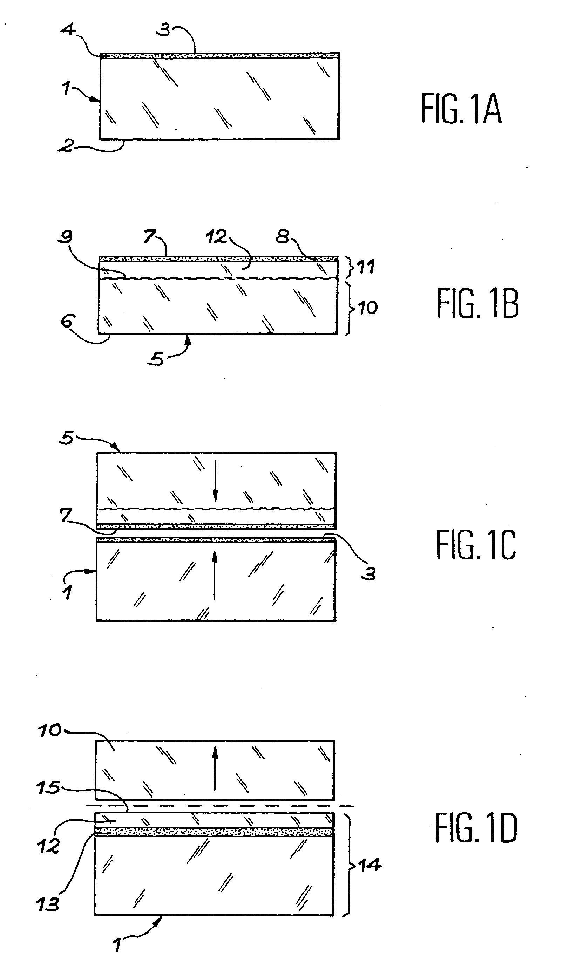

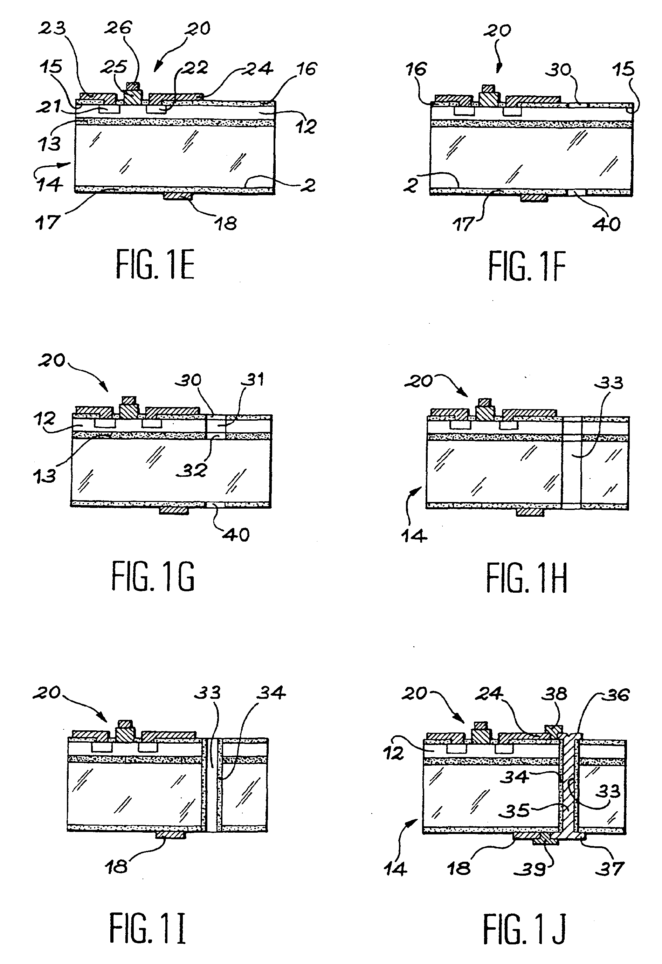

Un premier exemple de mise en oeuvre du procédé selon la présente invention va maintenant être décrit en référence aux figures 1A à 1J. Cet exemple concerne la réalisation d'un trou métallisé sur une structure comportant un transistor à effet de champ en carbure de silicium, ce trou métallisé permettant de relier électriquement la source du transistor à effet de champ à une ligne métallique déposée sur la face arrière de la structure. Le transistor est réalisé sur un film mince de carbure de silicium rapporté sur un substrat en silicium de forte résistivité.

La figure 1A représente un premier substrat 1 en silicium de haute résistivité et possédant une face arrière 2 et une face avant 3 qui ont été traitées pour être planes et parallèles entre elles. La face avant 3 a aussi été traitée pour présenter une couche d'oxyde thermique 4.

La figure 1B représente un deuxième substrat 5 en carbure de silicium et présentant une face arrière 6 et une face avant 7. Le substrat 5 est initialement constitué d'une masse de carbure de silicium qui a reçu, du côté de la face avant 7, des couches épitaxiées du même matériau. Une couche d'oxyde de silicium 8 a ensuite été déposée sur les couches épitaxiées. Afin de délimiter un film mince dans le substrat 5, des ions hydrogène ont été implantés à travers la face avant 7 jusqu'à une profondeur moyenne déterminée par leur énergie d'implantation. Ces ions implantés provoquent la formation d'une couche de microcavités 9 séparant le substrat 5 en deux régions : une région inférieure 10 et une région supérieure 11 comprenant la couche d'oxyde 8 et une partie 12 destinée à constituer le film mince. Pour plus de détails concernant ce procédé de fabrication d'un film mince par implantation ionique, on pourra se reporter au document FR-A-2 681 472.

La figure 1C illustre la mise en contact des substrats 1 et 5 par leurs premières faces 3 et 7 et leur solidarisation par une technique de collage atomique.

La figure 1D illustre l'étape d'élimination de la région 10 du deuxième substrat de l'ensemble solidarisé à l'étape précédente. Cette séparation en deux parties du deuxième substrat est obtenue par un traitement thermique de la couche 9 de microcavités comme l'enseigne le document FR-A-2 681 472. Ce traitement thermique est mené à une température suffisante pour réaliser une ligne de fracture au niveau de la couche de microcavités. On obtient une structure 14 formée par la superposition du premier substrat 1 en silicium, d'une couche d'oxyde de silicium 13 (résultant de l'empilement des couches d'oxyde 4 et 8) et du film mince de carbure de silicium 12 présentant une face libre 15.

La figure 1E représente la structure 14 sur laquelle un composant microélectronique 20, en l'occurrence un transistor à effet de champ, a été réalisé dans le film mince 12 en carbure de silicium. Le transistor 20 comporte des régions de drain 21 et de source 22 reliés respectivement à des électrodes de drain 23 et de source 24. La face libre 15 du film mince 12 supporte la grille 25 du transistor, qui est recouverte d'une électrode de grille 26. Une couche d'oxyde 16 déposée sur la face 15 du film mince 12 passive cette face et isole entre elles les électrodes du transistor 20. La face arrière 2 de la structure est également recouverte d'une couche d'oxyde 17. Une ligne métallique 18 a été réalisée par lithographie sur la couche d'oxyde 17. Elle est destinée à constituer une électrode sur la face arrière de la structure. L'électrode de la face arrière peut éventuellement couvrir toute cette face ("full sheet" dans la terminologie anglo-saxonne).

La phase suivante du procédé consiste à graver sélectivement chaque couche de la structure obtenue pour réaliser le trou traversant. Ceci est illustré par les figures 1F à 1H. La figure 1F montre la gravure des couches d'oxyde 16 et 17 recouvrant respectivement les faces 15 et 2 de la structure. Cette gravure laisse apparaître deux ouvertures alignées 30 et 40, respectivement dans les couches d'oxyde 16 et 17. Il peut s'agir d'une gravure sèche (CHF₃,Ar) puisque ces couches sont en silice.

La figure 1G montre la structure obtenue après gravure du film mince 12 et de la couche d'oxyde 13 en continuité de l'ouverture 30. Le film mince 12 en carbure de silicium peut être traité par gravure sèche (CHF₃,Ar). On obtient ainsi, dans le prolongement de l'ouverture 30, un trou 31 dans le film mince 12 et un trou 32 dans la couche d'oxyde 13.

Le trou traversant peut alors être obtenu par gravure profonde de la partie en silicium de la structure 14. On obtient le trou traversant 33 illustré par la figure 1H.

Le trou traversant peut éventuellement être obtenu directement, sans lithographie double face.

Selon la cinquième phase du procédé, les parois du trou 33 sont recouvertes d'une couche isolante 34, comme cela est illustré par la figure 1I.

On procède ensuite à la métallisation totale du trou 33 par dépôt d'une couche d'un métal de faible résistivité tel que de l'argent, de l'or, du cuivre, de l'aluminium, ou par dépôt de deux couches métalliques, la couche intermédiaire appelée couche barrière située entre le substrat et la couche de métal de faible résistivité ayant pour fonction d'éviter la diffusion du matériau de faible résistivité dans le substrat. Cette couche intermédiaire peut être, par exemple, en Ti, en TiN en Pt, en Ni, en TiW. Cette couche, réalisée dans les matériaux cités précédemment, peut permettre d'utiliser un procédé de dépôt du métal peu résistif par électrolyse. Néanmoins, il est à craindre que l'utilisaitn du TiN ne permette pas la réalisation d'un dépôt homogène de matériau peu résistif sur l'ensemble du sbustrat, parce que trop résistif.

La métallisation totale du trou 33 peut aussi être obtenue par dépôt de trois couches métalliques, la couche intermédiaire étant constituée de deux couches de matériau de barrière de diffusion précédemment cités.

La figure 1J montre la liaison électrique obtenue sous la référence 35. La liaison 35 déborde sur la face avant de la structure 14 par une extrémité 36 et sur la face arrière de la structure 14 par une extrémité 37.

Une étape de métallisation finale permet de raccorder électriquement la liaison 35 à l'électrode de source 24 sur la face avant de la structure et à la ligne métallique 18 sur la face arrière de la structure. La figure 1J montre les raccordements obtenus par l'étape de métallisation finale : un pont métallique 38 relie l'électrode de source 24 à l'extrémité 36 de la liaison 35, un pont métallique 39 relie la ligne métallique 18 à l'extrémité 37 de la liaison 35. Ces ponts métalliques sont définis par des étapes de lithographie et de gravure.

Un second exemple de mise en oeuvre du procédé selon la présente invention va maintenant être décrit. Il concerne la réalisation d'un trou métallisé permettant de relier la source d'un transistor à effet de champ en nitrure de gallium à une ligne métallique déposée en face arrière de la structure. Le film mince en nitrure de gallium est rapporté sur un substrat en silicium de forte résistivité.

Un premier substrat en silicium de haute résistivité, avec une couche d'oxyde thermique sur l'une de ses faces, est préparé. Il est identique à celui représenté à la figure 1A.

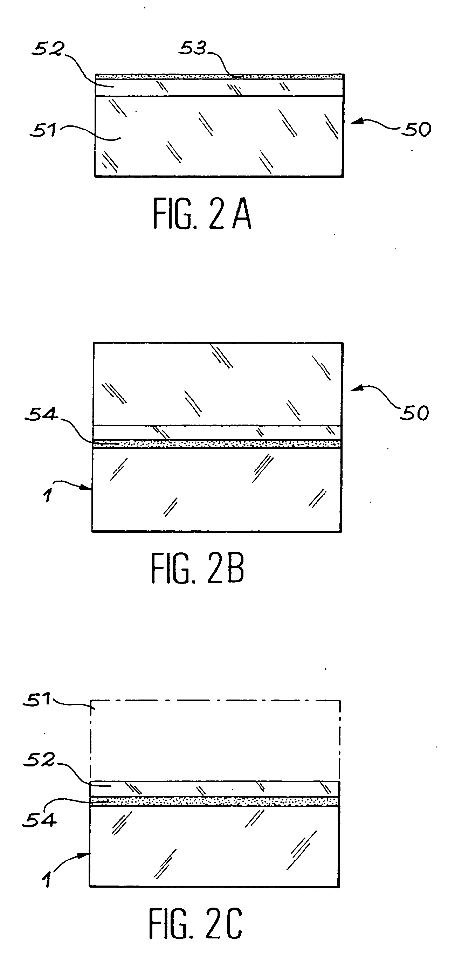

La figure 2A représente un deuxième substrat 50 constitué successivement d'une masse en carbure de silicium 51, d'une couche 52 de nitrure de gallium épitaxiée et d'une couche d'oxyde 53.

Les deux substrats sont mis en contact selon leurs faces oxydées et solidarisés par collage atomique. C'est ce que représente la figure 2B où la référence 54 désigne la couche d'oxyde résultant de l'empilement des couches d'oxyde 4 (voir la figure 1A) et 53 (voir la figure 2A).

On procède ensuite à un amincissement par rodage du deuxième substrat 50. Cet amincissement permet d'éliminer la masse 51 en carbure de silicium et de faire apparaître la couche 52 de nitrure de gallium qui constitue alors un film mince sur lequel sera élaboré le transistor à effet de champ. Ceci est illustré par la figure 2C.

Le procédé se déroule ensuite comme pour le premier exemple : réalisation du transistor à effet de champ, formation et métallisation du trou traversant, raccordement électrique du trou traversant métallisé à l'électrode de source du transistor d'une part et à la ligne métallique située sur la face arrière d'autre part.

## Revendications

1. Procédé de réalisation d'une structure comportant un composant microélectronique (20) réalisé dans un matériau semi-conducteur difficile à graver, comprenant la solidarisation d'un film mince (12,52) dudit matériau semi-conducteur difficile à graver sur la face avant (3) d'un premier substrat (1) en matériau facile à graver et servant de support, cette solidarisation fournissant ladite structure, **caractérisé en ce que** le composant microélectronique (20) est réalisé dans le film mince (12, 52), un trou traversant (33) est gravé dans la structure et métallisé (35) de façon à relier électriquement une électrode (18) formée sur la face arrière du premier substrat à une électrode (24) du composant microélectronique (20).

2. Procédé selon la revendication 1, **caractérisé en ce qu'**il comporte les étapes suivantes :
- préparation du premier substrat (1) pour lui conférer une face avant (3) et une face arrière (2) appropriées aux étapes suivantes,
- préparation d'un deuxième substrat (5,50) comportant ledit matériau semi-conducteur difficile à graver pour lui conférer une face avant (7) appropriée aux étapes suivantes,
- mise en contact intime du premier (1) et du deuxième substrat (5,50) par solidarisation de leurs faces avant,
- élimination d'une partie (10, 51) du deuxième substrat de façon à ne laisser subsister, sur la face avant du premier substrat, qu'un film mince (12,52) constitué dudit matériau semi-conducteur difficile à graver,
- réalisation du composant microélectronique (20) sur le film mince (12), avec ses électrodes (23,24,26),
- réalisation d'une électrode (18) sur la face arrière du premier substrat,
- réalisation d'un trou traversant (33) dans la structure, entre la face arrière du premier substrat et la face libre du film mince (12),
- métallisation du trou traversant et mise en contact électrique du trou traversant métallisé (33) d'une part avec une électrode (24) du composant microélectronique (20), d'autre part avec électrode (18) située sur la face arrière du premier substrat.

3. Procédé selon la revendication 2, **caractérisé en ce que** l'étape de préparation du premier substrat (1) comporte le recouvrement de la face avant de ce premier substrat par une couche isolante (4).

4. Procédé selon l'une des revendications 2 ou 3, **caractérisé en ce que** l'étape de préparation du deuxième substrat (5,50) comporte le recouvrement de la face avant (7) de ce deuxième substrat par une couche isolante (8,53).

5. Procédé selon l'une quelconque des revendications 2 à 4, **caractérisé en ce qu'**il est prévu, lors de l'étape de préparation du deuxième substrat (5), une implantation ionique de ce deuxième substrat au travers de sa face avant afin de délimiter ledit film mince (12) grâce à la formation d'une couche de microcavités (9) dans le deuxième substrat, l'implantation ionique étant menée avec une dose suffisante pour permettre la création d'une ligne de fracture le long de la couche de microcavités (9) lors d'un traitement thermique de la couche de microcavités réalisé au cours de l'étape consistant à éliminer une partie (10) du deuxième substrat.

6. Procédé selon l'une quelconque des revendications 2 à 4, **caractérisé en ce que** l'élimination de ladite partie (51) du deuxième substrat (50) se fait par usinage mécanique.

7. Procédé selon l'une quelconque des revendications 2 à 6, **caractérisé en ce que** le trou traversant (33) est réalisé par gravure.

8. Procédé selon l'une quelconque des revendications 2 à 7, **caractérisé en ce qu'**il est prévu en outre une étape d'isolation électrique des parois du trou traversant (33).

9. Procédé selon l'une quelconque des revendications 1 à 8, **caractérisé en ce que** le matériau facile à graver est du silicium, du quartz, de l'alumine, du saphir ou de l'arséniure de gallium.

10. Procédé selon l'une quelconque des revendications 1 à 9, **caractérisé en ce que** le matériau semi-conducteur difficile à graver est du carbure de silicium ou du nitrure de gallium.

11. Structure comportant un composant microélectronique (20) réalisé dans un matériau semi-conducteur difficile à graver, la structure comprenant un film mince (12,52) dudit matériau difficile à graver et dans lequel est réalisé le composant microélectronique, le film mince étant solidaire de la face avant (3) d'un premier substrat (1) en matériau facile à graver et dont la face arrière du premier substrat supporte une électrode (18), un trou traversant métallisé (35) reliant électriquement l'électrode arrière (18) du premier substrat à une électrode (24) du composant microélectronique (20).

12. Structure selon la revendication 11, **caractérisée en ce que** le matériau difficile à graver est du carbure de silicium ou du nitrure de gallium.

13. Structure selon la revendication 11, **caractérisée en ce que** ledit film mince est constitué par un empilement de couches du carbure de silicium et/ou de nitrure de gallium de conductivités électriques différentes.

14. Structure selon l'une quelconque des revendications 11 à 13, **caractérisée en ce que** le matériau facile à graver est du silicium, du quartz, de l'alumine, du saphir ou de l'arséniure de gallium.

15. Structure selon l'une quelconque des revendications 11 à 14, **caractérisée en ce qu'**une couche isolante (13) sépare le film mince (12) du matériau facile à graver.

16. Structure selon la revendication 15, **caractérisée en ce que** la couche isolante est en SiO₂, AlN, Al₂O₃ ou Si₃N₄.

17. Structure selon l'une quelconque des revendications 11 à 16, **caractérisée en ce que** les parois du trou traversant (33) sont revêtues d'un isolant électrique (34).

18. Structure selon l'une quelconque des revendications 11 à 17, **caractérisée en ce que** le trou traversant est métallisé par une couche d'un métal de faible résistivité.

19. Structure selon la revendication 18, **caractérisée en ce que** le métal de faible résistivité est choisi parmi l'argent, l'or, le cuivre et l'aluminium.

20. Structure selon l'une des revendications 18 ou 19, **caractérisée en ce qu'**il est prévu une couche barrière sous la couche de métal de faible résistivité, la couche barrière évitant la diffusion du métal de faible résistivité.

21. Structure selon l'une quelconque des revendications 11 à 20, **caractérisée en ce que** le composant microélectronique (20) est un transistor à effet de champ.

## Claims

1. Method of producing a structure comprising a micro-electronic component (20) produced in a semiconductor material difficult to etch comprising carrying out the rigid fixing of a thin film (12, 52) of said semiconductor material difficult to etch onto the front face (3) of a first substrate (1) made of material easy to etch and serving as a support, this rigid fixing providing said structure, **characterized in that** the micro-electronic component (20) is produced in the thin film (12, 52), a through hole (33) is etched in the structure and metallized (35) in a way that electrically connects an electrode (18) formed on the rear face of the first substrate to an electrode (24) of the micro-electronic component (20).

2. Method according to claim 1, **characterized in that** it comprises the following steps:
- preparation of the first substrate (1) to provide it with a front face (3) and a rear face (2) suitable for the following steps,
- preparation of a second substrate (5, 50) comprising said semiconductor material difficult to etch in order to provide it with a front face (7) suitable for the following steps,
- bringing the first (1) and second (5, 50) substrates into intimate contact through the rigid fixing of their front faces,
- removal of a part (10, 51) of the second substrate in such a way that only a thin film (12, 52) made of the semiconductor material difficult to etch is allowed to remain on the front face of the first substrate,
- creation of the micro-electronic component (20) on the thin film (12), with its electrodes (23, 24, 26),
- creation of an electrode (18) on the rear face of the first substrate,
- creation of a hole (33) passing through the structure, between the rear face of the first substrate and the free face of the thin film (12),
- metallization of the through hole and the making of electrical contact between this metallized hole (33) and, on the one hand an electrode (24) of the micro-electronic component (20), and on the other hand an electrode (18) situated on the rear face of the first substrate.

3. Method according to claim 2, **characterized in that** the step of preparing the first substrate (1) comprises covering of the front face of this first substrate with an insulating layer (4).

4. Method according to claims 2 or 3, **characterized in that** the step of preparing the second substrate (5, 50) comprises the covering of the front face (7) of this second substrate with an insulating layer (8, 53).

5. Method according to any one of the claims 2 to 4, **characterized in that** provision is made, during the step of preparing the second substrate (5), for an ionic implantation of this second substrate through its front face so as to demarcate said thin film (12) with the formation of a layer of micro-cavities (9) in the second substrate, the ionic implantation being made with a dose that is sufficient to permit the creation of a fracture line along the layer of micro-cavities (9) during a heat treatment of the layer of micro-cavities carried out in the course of the step consisting of removing a part (10) of the second substrate.

6. Method according to any one of the claims 2 to 4, **characterized in that** the removal of said part (51) of the second substrate (50) is carried out by mechanical machining.

7. Method according to any one of the claims 2 to 6, **characterized in that** the through hole (33) is produced by etching.

8. Method according to any one of the claims 2 to 7, **characterized in that** in addition, a step of electrically insulating the walls of the through hole (33) is provided.

9. Method according to any one of the claims 1 to 8, **characterized in that** the material that is easy to etch is silicon, quartz, alumina, sapphire or gallium arsenide.

10. Method according to any one of the claims 1 to 9, **characterized in that** the semiconductor material that is difficult to etch is silicon carbide or gallium nitride.

11. Structure comprising a micro-electronic component (20) produced in a semiconductor material difficult to etch, said structure comprising a thin film (12, 52) of said material that is difficult to etch and in which the micro-electronic component is produced, the thin film being rigidly fixed onto the front face (3) of a first substrate (1) made of material easy to etch the rear face of which supports an electrode (18), a metallized through hole (35) electrically connecting the rear electrode (18) of the first substrate to an electrode (24) of the micro-electronic component (20).

12. Structure according to claim 11, **characterized in that** the material difficult to etch is silicon carbide or gallium nitride.

13. Structure according to claim 11, **characterized in that** said thin film is made up by a stacking of layers of silicon carbide and/or gallium nitride of different electrical conductivities.

14. Structure according to any one of the claims 11 to 13, **characterized in that** the material that is easy to etch is silicon, quartz, alumina, sapphire or gallium arsenide.

15. Structure according to any one of the claims 11 to 14, **characterized in that** an insulating film separates the thin film from the material that is easy to etch.

16. Structure according to claim 15, **characterized in that** the insulating layer is SiO₂, AlN, Al₂O₃ or Si₃N₄.

17. Structure according to any one of the claims 11 to 16, **characterized in that** the walls of the through hole (33) are lined with an electrical insulator (34).

18. Structure according to any one of the claims 11 to 17, **characterized in that** the through hole is metallized by a layer of metal of low resistivity.

19. Structure according to claim 18, **characterized in that** the metal of low resistivity is chosen from among silver, gold, copper and aluminium.

20. Structure according to one of the claims 18 and 19, **characterized in that** a barrier layer is provided under the layer of metal of low resistivity, the barrier layer preventing the diffusion of the metal of low resistivity.

21. Structure according to any one of the claims 11 to 20, **characterized in that** the micro-electronic component (20) is a field effect transistor.

## Patentansprüche

1. Verfahren zur Herstellung einer ein mikroelektronisches Bauteil (20) aus einem schwierig zu ätzenden Halbleitermaterial enthaltenden Struktur, das die Vereinigung einer Dünnschicht (12, 52) des schwierig zu ätzenden Materials mit der Vorderseite (3) eines als Träger dienenden ersten Substrats (1) aus leicht zu ätzendem Material umfasst, wobei diese Vereinigung die genannte Struktur ergibt,
**dadurch gekennzeichnet, dass** das mikroelektronische Bauteil (20) in der Dünnschicht (12, 52) realisiert wird, wobei ein Durchgangsloch (33) in die Struktur geätzt und derartig metallisiert wird (35), dass es eine auf der Rückseite des ersten Substrats ausgebildete Elektrode (18) mit einer Elektrode (24) des mikroelektronischen Bauteils (20) verbindet.

2. Verfahren nach Anspruch 1, **dadurch gekennzeichnet, dass** es die folgenden Schritte umfasst:
- Vorbereiten des ersten Substrats (1) durch Realisierung einer Vorderseite (3) und einer Rückseite (2), so dass sie für die nachfolgenden Schritte geeignet sind,
- Vorbereiten eines zweiten Substrats (5, 50) aus dem genannten schwierig zu ätzende Halbleitermaterial durch Realisierung einer für die nachfolgenden Schritte geeignete Vorderseite (7),
- Herstellen eines engen Kontakts zwischen dem ersten Substrat (1) und dem zweiten Substrat (5, 50) durch Vereinigung ihrer Vorderseiten,
- Eliminieren eines Teils (10, 51) des zweiten Substrats, so dass auf der Vorderseite des ersten Substrats nur eine Dünnschicht (12, 52) zurückbleibt, gebildet durch das genannte schwierig zu ätzende Material,
- Realisieren des mikroelektronischen Bauteils (20) in der Dünnschicht (12), mit seinen Elektroden (23, 24, 26),
- Realisieren einer Elektrode (18) auf der Rückseite des ersten Substrats,
- Realisieren eines Durchgangslochs (33) in der Struktur, zwischen der Rückseite des ersten Substrats und der freien Seite der Dünnschicht (12),
- Metallisieren des Durchgangslochs und Herstellen des elektrischen Kontakts mit einerseits der Elektrode (24) des mikroelektronischen Bauteils (20) und andererseits der Elektrode (18), die sich auf der Rückseite des ersten Substrats befindet.

3. Verfahren nach Anspruch 2, **dadurch gekennzeichnet, dass** der Vorbereitungsschritt des ersten Substrats (1) das Überziehen der Vorderseite dieses ersten Substrats mit einer Isolierschicht (4) umfasst.

4. Verfahren nach Anspruch 2, **dadurch gekennzeichnet, dass** der Vorbereitungsschritt des zweiten Substrats (5, 50) das Überziehen der Vorderseite (7) dieses zweiten Substrats mit einer Isolierschicht (8, 53) umfasst.

5. Verfahren nach einem der Ansprüche 2 bis 4, **dadurch gekennzeichnet, dass** während des Vorbereitungsschritts des zweiten Substrats (5) eine lonenimplantation dieses zweiten Substrats stattfindet, durch seine Vorderseite hindurch, um die genannte Dünnschicht (12) dank der Bildung einer Mikrohohlräume-Schicht (9) in dem zweiten Substrat abzugrenzen, wobei die lonenimplantation mit einer Dosis durchgeführt wird, die ausreicht zur Erzeugung einer Bruchlinie längs der Mikrohohlräume-Schicht (9) während einer thermischen Behandlung der Mikrohohlräume-Schicht, die während des Schritts erfolgt, der dazu bestimmt ist, einen Teil (10) des zweiten Substrats zu eliminieren.

6. Verfahren nach einem der Ansprüche 2 bis 4, **dadurch gekennzeichnet, dass** das Eliminieren des genannten Teils (51) des zweiten Substrats (50) durch mechanische Bearbeitung erfolgt.

7. Verfahren nach einem der Ansprüche 2 bis 6, **dadurch gekennzeichnet, dass** das Durchgangsloch (33) durch Ätzung realisiert wird.

8. Verfahren nach einem der Ansprüche 2 bis 7, **dadurch gekennzeichnet, dass** außerdem ein Schritt zur elektrischen Isolierung der Wände des Durchgangslochs (33) vorgesehen ist.

9. Verfahren nach einem der Ansprüche 1 bis 8, **dadurch gekennzeichnet, dass** das leicht zu ätzende Material Silicium, Quarz, Aluminiumoxid, Saphir oder Galliumarsenid ist.

10. Verfahren nach einem der Ansprüche 1 bis 9, **dadurch gekennzeichnet, dass** das schwierig zu ätzende Material Siliciumkarbid oder Galliumnitrid ist.

11. Struktur mit einem mikroelektronischen Bauteil (20) aus einem schwierig zu ätzenden Halbleitermaterial, wobei die Struktur eine Dünnschicht (12, 52) des schwierig zu ätzenden Materials umfasst, in der das mikroelektronische Bauteil realisiert ist, bei der die Dünnschicht mit der Vorderseite (3) eines ersten Substrats (1) aus leicht zu ätzendem Material des ersten Substrats vereint ist und bei der die Rückseite des ersten Substrats eine Elektrode (18) trägt, wobei ein metallisiertes Durchgangsloch (35) die rückseitige Elektrode (18) des ersten Substrats mit einer Elektrode (24) des mikroelektronischen Bauteils (20) verbindet.

12. Struktur nach Anspruch 11, **dadurch gekennzeichnet, dass** das schwierig zu ätzende Material Siliciumkarbid oder Galliumnitrid ist.

13. Struktur nach Anspruch 11, **dadurch gekennzeichnet, dass** die genannte Dünnschicht durch einen Stapel aus Siliciumkarbid- und/oder Galliumnitridschichten mit unterschiedlicher elektrischer Leitfähigkeit gebildet wird.

14. Struktur nach einem der Ansprüche 11 bis 13, **dadurch gekennzeichnet, dass** das leicht zu ätzende Material Silicium, Quarz, Aluminiumoxid, Saphir oder Galliumarsenid ist.

15. Struktur nach einem der Ansprüche 11 bis 14, **dadurch gekennzeichnet, dass** eine Isolierschicht (13) die Dünnschicht (12) von dem leicht zu ätzenden Material trennt.

16. Struktur nach Anspruch 15, **dadurch gekennzeichnet, dass** die Isolierschicht aus SiO₂, AlN, Al₂O₃ oder Si₃N₄ ist.

17. Struktur nach einem der Ansprüche 11 bis 16, **dadurch gekennzeichnet, dass** die Wände des Durchgangslochs (33) mit einem elektrischen Isolationsmaterial (34) überzogen sind.

18. Struktur nach einem der Ansprüche 11 bis 17, **dadurch gekennzeichnet, dass** die Wände des Durchgangslochs (33) mittels einer Schicht aus einem Metall mit schwacher Resistivität überzogen sind.

19. Struktur nach Anspruch 18, **dadurch gekennzeichnet, dass** das schwach resistive Metall ausgewählt wird unter Silber, Gold, Kupfer und Aluminium.

20. Struktur nach einem der Ansprüche 18 oder 19, **dadurch gekennzeichnet, dass** eine Sperrschicht vorgesehen ist unter der Schicht aus schwach resistivem Metall, wobei diese Sperrschicht die Diffusion des schwach resistiven Metalls verhindert.

21. Struktur nach einem der Ansprüche 11 bis 20, **dadurch gekennzeichnet, dass** das mikroelektronische Bauteil (20) ein Feldeffekttransistor ist.
